(19) Europäisches Patentamt
European Patent Office
Office européen des brevets

(11) **EP 4 213 196 A1**

(12) **EUROPEAN PATENT APPLICATION**
published in accordance with Art. 153(4) EPC

(43) Date of publication:
**19.07.2023 Bulletin 2023/29**

(21) Application number: **21864407.8**

(22) Date of filing: **02.09.2021**

(51) International Patent Classification (IPC):
**H01L 23/12** (2006.01)  **G09F 9/00** (2006.01)
**G09F 9/33** (2006.01)  **H05K 3/20** (2006.01)
**H05K 3/32** (2006.01)

(52) Cooperative Patent Classification (CPC):
**G09F 9/00; G09F 9/33; H01L 23/12; H05K 3/20; H05K 3/32**

(86) International application number:
**PCT/JP2021/032305**

(87) International publication number:
**WO 2022/050354 (10.03.2022 Gazette 2022/10)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **07.09.2020 JP 2020150004**

(71) Applicant: **Daicel Corporation**
**Osaka 530-0011 (JP)**

(72) Inventor: **MIYAKE, Hiroto**
**Tokyo 108-8230 (JP)**

(74) Representative: **Grünecker Patent- und Rechtsanwälte**
**PartG mbB**
**Leopoldstraße 4**
**80802 München (DE)**

(54) **MOUNTING STRUCTURE, LED DISPLAY, AND MOUNTING METHOD**

(57)    There are provided a mounted structure from which such a mounted structure can be obtained that is excellent in precision with little joining deviation and can be efficiently produced, an LED display, and a mounting method. A mounted structure is provided in which a semiconductor element including a terminal is mounted on a substrate including an electrode. The mounted structure includes a joining portion in which the terminal and the electrode are joined opposing each other. The electrode is a bump of a bulk metal material disposed on the substrate. The joining portion is produced by thermally fusing metal nanoparticles, the metal nanoparticles being deposited from a metal complex by laser irradiation, the metal complex having been transferred onto at least one of the electrode or the terminal by using a microcontact printing method.

FIG. 7

EP 4 213 196 A1

**Description**

Technical Field

The present disclosure relates to a mounted structure in which a semiconductor element is mounted on a substrate, an LED display including the mounted structure, and a mounting method for mounting the semiconductor element on the substrate. The present application claims priority to JP 2020-150004 filed in Japan on September 7, 2020, the content of which is incorporated herein.

Background Art

As a method for producing a printed circuit wiring board that is used in forming an electronic circuit by fixing electronic components onto a surface of the printed circuit wiring board and connecting the electronic components with wiring lines, a method (subtractive method) is known in which a material with a metal layer formed on the entire surface of an insulating substrate by a wet process (nonelectrolytic plating, electrolytic plating, or the like) or by a dry process (vacuum vapor deposition, sputtering, or the like) is used as a starting material, an unwanted portion of the metal layer of the starting material is etched utilizing a mask formed by using a photolithographic method, and metal wiring lines are formed by removing the mask after the completion of the etching. In recent years, the printed circuit wiring boards have been required to form finer wiring patterns to facilitate the densification of wiring boards accompanying the developments in miniaturization and functionality of electronic devices, but it is difficult for the subtractive method to precisely form a fine wiring pattern. The forming of a bump for connecting devices on the wiring lines and the joining the contact points with each other require significantly high precision, and therefore are carried out through complex processes.
In particular, in display devices such as displays equipped with precision components such as micro LEDs, as miniaturization is carried on, higher resolution is required. For example, in a micro LED display ($\mu$-LED), about 24.9 million micro LEDs (three types of R, G, B) need to be precisely disposed on one substrate at 4K resolution. When the micro LEDs are disposed one by one on the substrate, the process needs a long-term. Because of this, it is required to efficiently form the wiring pattern. To meet this requirement, an ink-jet scheme is known as a method for forming a finer wiring pattern on a substrate at once (Patent Document 1). In the ink-jet scheme of Patent Document 1, a wiring pattern is formed on the substrate by discharging a metal nanoparticle paste through a nozzle onto the substrate and then heating. In addition, a contact printing scheme is also reported in which a paste containing conductive particles is applied on a surface of a resin template having been subjected to patterning including recesses and protrusions, and the surface of the resin template is pressed against a $SiO_2$/Si substrate, thereby forming a pattern of the conductive material on the substrate (Patent Document 2). A production method is also reported in which a composition layer is formed by imparting a composition containing a copper complex to a substrate, and laser irradiation is performed on the composition layer to deposit copper, thereby producing a conductor on the substrate (Patent Document 3).

Citation List

Patent Document

Patent Document 1: JP 4539284 B
Patent Document 2: JP 2007-110054 A
Patent Document 3: WO 2018/212345

Summary of Invention

Technical Problem

The ink-jet scheme of Patent Document 1 is a method of directly discharging a metal nanoparticle paste through a nozzle onto a substrate. At this time, the metal nanoparticle paste may scatter, blur, or spread on the substrate when observed at the nano-level. Due to this, there is a risk of a reduction in precision of the wiring pattern. In the contact printing scheme of Patent Document 2, a silver nano-paste is applied on a resin template to form a layer of the silver nano-paste having ups and downs according to the recesses and protrusions on the template. Thereafter, the template is pressed against the substrate to transfer only the silver nano-paste applied to the protruding portions onto the $SiO_2$/Si substrate. As a result, the silver nano-paste applied to the recessed portions of the template remains after the transfer, and therefore it is necessary to eliminate the remaining silver nano-paste by washing for successive use of the template.

Accordingly, there is a risk that the same template cannot be used successively, thereby causing a reduction in production efficiency. In the production method for producing a conductor of Patent Document 3, only the formation of the conductor on the substrate is carried out, and it is not disclosed that a semiconductor element can be mounted thereon with little joining deviation on the substrate.

Thus, an object of the present disclosure is to provide: a mounted structure which is excellent in precision with little joining deviation and can be produced efficiently, and in which a semiconductor element is mounted on a substrate; an LED display including the mounted structure; and a mounting method for mounting the semiconductor element on the substrate.

Solution to Problem

Through extensive study to accomplish the object described above, the inventors of the present disclosure have found that it is possible to achieve a mounted structure that is excellent in precision with little joining deviation and can be produced efficiently by depositing metal nanoparticles, by laser irradiation, from a metal complex transferred onto an electrode which is a bump of a bulk metal material disposed on the substrate, by using a microcontact printing method. The present disclosure has been completed based on these findings.

That is, the present disclosure provides a mounted structure in which a semiconductor element including a terminal is mounted on a substrate including an electrode. The mounted structure includes a joining portion in which the terminal and the electrode are joined opposing each other, the electrode is a bump of a bulk metal material disposed on the substrate, and the joining portion is produced by thermally fusing metal nanoparticles, the metal nanoparticles being deposited from a metal complex by laser irradiation, the metal complex having been transferred onto at least one of the electrode or the terminal by using a microcontact printing method.

In addition, the present disclosure provides a mounting method for mounting a semiconductor element including a terminal onto a substrate including an electrode. The electrode is a bump of a bulk metal material disposed on the substrate. The mounting method includes transferring a metal complex onto at least one of the electrode or the terminal by using a microcontact printing method, depositing metal nanoparticles from the metal complex by laser irradiation, and performing thermal fusion in a state in which the terminal and the electrode are in contact with and oppose each other via the deposited metal nanoparticles.

It is preferable that the above-described metal complex include a copper complex formed of a keto acid and a copper ion, and a copper complex formed of a copper ion and a ligand containing a nitrogen atom.

A mold used in the microcontact printing method described above preferably contains polysiloxane as a constituent material.

The mold used in the microcontact printing method preferably uses a mold made of a film or a mold made of polysiloxane including a fibrous core material, a linear expansion coefficient of the mold being 200 ppm/K or less and a size of the mold being unchanged before and after being used repeatedly using a solvent.

It is preferable that the laser irradiation be performed using a $CO_2$ laser or an Er laser.

The semiconductor element is preferably an LED element in which the length of the longest line among the lines connecting any two points on the outer periphery of the semiconductor element in a plan view is 100 $\mu$m or less.

The present disclosure provides an LED display including the mounted structure described above.

Advantageous Effects of Invention

According to the mounted structure or the mounting method of the present disclosure, it is possible to achieve the mounted structure that is excellent in precision with little joining deviation and can be produced efficiently. In addition, the mounted structure of the present disclosure may be suitably used as an LED display.

Brief Description of Drawings

FIG. 1(A) is a perspective view in which part of a mounted structure of the present disclosure is enlarged and illustrated, and FIG. 1(B) is a partial cross-sectional view of FIG. 1(A).

FIG. 2(A) is a plan view in which part of a mounted structure of the present disclosure is enlarged and illustrated, and FIG. 2(B) is a plan view in which part of a modified example of a mounted structure of the present disclosure is enlarged and illustrated.

FIG. 3(A) is a plan view of a master mold, FIG. 3(B) is a partially enlarged plan view of FIG. 3(A), and FIG. 3(C) is a partially enlarged plan view of FIG. 3(B).

FIGS. 4(A) to 4(E) are schematic diagrams illustrating an example of a method for forming a mold.

FIGS. 5(A) to 5(E) are schematic diagrams illustrating an example of transfer by a microcontact printing method.
FIGS. 6(A) to 6(E) are schematic diagrams illustrating a mounting method of the present disclosure.
FIG. 7 is a flowchart illustrating a mounting method of the present disclosure.

Description of Embodiments

Hereinafter, embodiments for carrying out the present disclosure will be described. Note that each of the configurations, combinations thereof, and the like in each of the embodiments are an example, and various additions, omissions, substitutions, and other changes may be made as appropriate without departing from the spirit of the present disclosure. The present disclosure is not limited to the embodiments and is limited only to the claims.

Mounted Structure

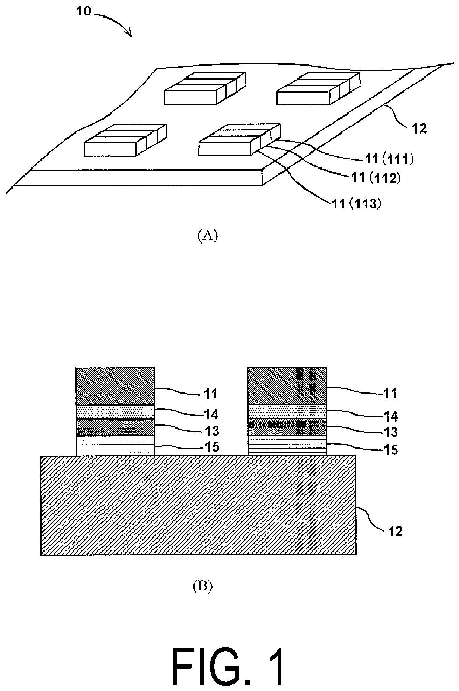

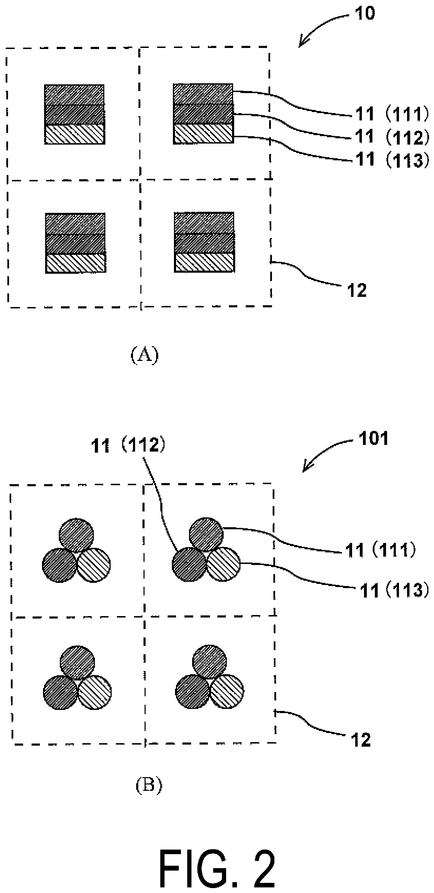

FIG. 1(A) is a perspective view in which part of a mounted structure (hereinafter, also referred to as simply a mounted structure) 10 of the present disclosure is enlarged and illustrated, and FIG. 1(B) is a partial cross-sectional view of FIG. 1(A). FIG. 2(A) is a plan view in which part of the mounted structure 10 is enlarged and illustrated, and FIG. 2(B) is a plan view in which part of a modified example of the mounted structure 10 is enlarged and illustrated. In FIG. 1(A), only a semiconductor element 11 and a substrate 12 are illustrated, and the other members are omitted. As illustrated in FIG. 1(A), FIG. 1(B), and FIG. 2(A), the mounted structure 10 includes a plurality of semiconductor elements 11, the substrate 12, and a plurality of joining portions 13. The semiconductor element 11 includes a terminal 14, and the substrate 12 includes an electrode 15. The semiconductor element 11 is mounted on the substrate 12 in such a manner that the terminal 14 and the electrode 15 oppose each other. The joining portion 13 joins the terminal 14 and the electrode 15. That is, the plurality of semiconductor elements 11 are each mounted on the substrate 12 with the joining portion 13 interposed therebetween.

The semiconductor element 11 is an electronic component using a semiconductor, and particularly indicates a microscale element herein. The semiconductor elements 11 include a semiconductor element 111, a semiconductor element 112, and a semiconductor element 113. For example, the semiconductor element 111 is a red micro LED, the semiconductor element 112 is a green micro LED, and the semiconductor element 113 is a blue micro LED. One pixel is constituted of one semiconductor element 111, one semiconductor element 112, and one semiconductor element 113. A plurality of the pixels each constituted of the semiconductor element 111, semiconductor element 112, and semiconductor element 113 are disposed being aligned at predetermined intervals on the substrate 12. In the present embodiment, three types of micro LEDs are given as examples of the semiconductor elements 11, but in accordance with the specifications, all the micro LEDs may be the same type, or a plurality of micro LEDs other than the above three types may be included. The size, the shape, the number of elements, and the like may be different depending on the luminance or the like of the individual semiconductor elements. For example, one pixel may be constituted by a combination of four semiconductor elements 11 including one semiconductor element 111, one semiconductor element 112, and two semiconductor elements 113.

The length of the longest line among the lines connecting any two points on the outer periphery of the semiconductor element 11 in a plan view is preferably 100 $\mu$m or less. In the following, the plan view indicates a view when seen from a direction perpendicular to a planar direction of the substrate 12 or the like. To be specific, the semiconductor element 11 (111, 112, 113) is formed in a rectangular shape having a diagonal line of 100 $\mu$m or less in length in a plan view, for example. When the semiconductor element 11 has a rectangular shape in a plan view, the length of the diagonal line is more preferably 70 $\mu$m or less, and further more preferably 35 $\mu$m or less.

FIG. 2(B) illustrates a mounted structure 101, which is a modified example of the mounted structure 10. In the description of the mounted structure 101, description similar to that of the mounted structure 10 is omitted, and only different portions are described. As illustrated in FIG. 2(B), the semiconductor element 11 (111, 112, 113) is formed in a circular shape having a diameter of 100 $\mu$m or less. When the semiconductor element 11 has a circular shape in a plan view, the diameter thereof is more preferably 50 $\mu$m or less, and further more preferably 20 $\mu$m or less. The shape of the semiconductor element 11 is not limited to a rectangular shape or a circular shape, and other shapes such as a polygonal shape, an elliptical shape and the like may be employed in accordance with the specifications.

The substrate 12 is a planar substrate including the electrode 15. Examples of the planar substrate include a glass plate; a semiconductor such as silicon, gallium arsenide, gallium nitride or the like; a composite substrate obtained by a base material such as glass cloth, nonwoven fabric or the like being impregnated with resin such as an epoxy resin and being cured: a resin substrate of an epoxy resin cured product, an engineering plastic such as a liquid crystal polymer, polycarbonate, polypropylene, polyethylene or the like; a metal substrate; and a combination of these materials. The substrate 12 may include, in addition to the electrode 15, a pattern structure such as a fine wiring line, a crystalline structure, an optical waveguide, an optical structure such as holography or the like, as needed.

The substrate 12 is preferably formed in a rectangular shape having a diagonal line of 600 mm or less in length in a plan view, for example. When the semiconductor element 11 has a rectangular shape in a plan view, the length of the diagonal line is more preferably 100 mm or less, and further more preferably 75 mm or less. The shape of the substrate 12 is not limited to a rectangular shape, and other shapes such as a polygonal shape, a circular shape, an elliptical shape and the like may be employed in accordance with the specifications.

The electrode 15 is a bump (protrusion) of a bulk metal material disposed on the substrate 12. It is preferable that the bulk metal material be electrically conductive and have low resistance. Examples of components constituting the bulk metal material include metal, metal salts such as metal oxide, carbon and the like. The components constituting the bulk metal material may be composed of only one type of component, or may include a plurality of types of components. Among the above-mentioned components, metal is preferred as the component constituting the bulk metal material. The metal may be, for example, a single element such as gold, silver, palladium, platinum, nickel, copper, iron, lead, lithium, cobalt, manganese, aluminum, zinc, bismuth, silicon, tin, cadmium, indium or the like, a plurality of elements of these metals, or metal oxides or salts of these metals.

The electrode 15 is disposed on the substrate 12 in accordance with the specifications of the mounted structure 10. The electrode 15 is disposed at a position corresponding to each of the semiconductor elements 11, for example.

The joining portion 13 includes a material having electrical conductivity. Examples of the material having electrical conductivity include metal, metal salts such as metal oxide, and a mixture of these materials. Among these, the metal is preferably used for thermally fusing the terminal 14 and the electrode 15. Examples of the metal include gold, silver, palladium, platinum, nickel, copper, iron, lead, lithium, cobalt, manganese, aluminum, zinc, bismuth, silicon, tin, cadmium, indium and the like. Among the metals, a metal unlikely to be oxidized is preferred. Copper is particularly preferred among the metals. Copper is inexpensive and is unlikely to be oxidized when it is in the form of a nano-size particle, and therefore copper may be easily handled in the atmosphere. This makes it possible to easily join the terminal 14 and the electrode 15 in the atmosphere.

The joining portion 13 is formed, for example, by thermally fusing the metal nanoparticles made of the metal described above. Regarding the heating conditions of the thermal fusion, the temperature is preferably in a range from 100°C to 200°C, more preferably in a range from 100°C to 150°C, and further more preferably in a range from 100°C to 120°C. When the temperature is 100°C or higher, the metal nanoparticles may be sufficiently fused and integrated. The heating time is preferably 120 minutes or less, more preferably 15 minutes or less, and further more preferably 5 minutes or less. This makes it possible to sufficiently join the terminal 14 and the electrode 15. The joining portion 13 may be mixed and integrated with part of the terminal 14 and the electrode 15, which are fused by the thermal fusion. With this, the terminal 14 may be more firmly joined to the electrode 15.

Metal nanoparticles are deposited by laser irradiation from a metal complex contained in a metal complex composition. The metal complex composition is a composition transferred onto the electrode 15 by using the microcontact printing method. The metal complex composition may be transferred onto the terminal 14 on the semiconductor element 11 side instead of being transferred onto the electrode 15 on the substrate 12 side. The metal complex composition may be transferred onto both the electrode 15 and the terminal 14. In other words, it is sufficient that the metal complex composition is transferred onto at least one of the electrode 15 or the terminal 14.

The microcontact printing method may transfer the metal complex composition containing the metal complex to a plurality of locations at a time by using a mold described below. When metal nanoparticles formed of the metal complex are used for forming the joining portion 13, the usage amount of metal may be reduced compared to the case of using a bulk metal, and the metal may be disposed in a fine region by using the microcontact printing method. The transfer by the microcontact printing method will be described in detail later.

A method of depositing metal nanoparticles from the metal complex contained in the metal complex composition by using laser irradiation treatment will be described below. Although copper is taken as an example of the metal herein, any metal can be used as long as metal nanoparticles can be deposited therefrom in a similar manner.

It is preferable that a copper complex composition be a composition including a first copper complex formed of a keto acid and a copper ion, and a second copper complex formed of a copper ion and a ligand containing a nitrogen atom, for example.

The first copper complex is preferably formed of a keto acid and a copper ion (keto acid copper). Examples of the first copper complex include $\alpha$-keto acid copper, $\beta$-keto acid copper and $\gamma$-keto acid copper, such as glyoxylic acid copper. The first copper complex may be one type among these materials, or a combination of two or more types thereof. The second copper complex is preferably formed of a copper ion and a ligand containing a nitrogen atom. Examples of the second copper complex include monoalkylamine copper complexes ($C_nH_{2n+1}NH_2Cu$: n is an integer) such as a methylamine copper complex, an ethylamine copper complex and the like, and amine-based copper complexes such as a dialkylamine copper complex, a trialkylamine copper complex, an ethylene diamine copper complex, an ethanolamine copper complex and the like. The second copper complex may be one type among these materials, or a combination of two or more types thereof.

The content ratio of the first copper complex and the second copper complex contained in the copper complex composition is not particularly limited, but is preferably in a range from 90 wt.% to 5 wt.% of the whole composition, and more preferably in a range from 80 wt.% to 10 wt.%, for example. The molar ratio of the first copper complex and the second copper complex contained in the copper complex composition (first copper complex: second copper complex) is not particularly limited, but is preferably in a range from 9:1 to 1:9, and more preferably in a range from 8:2 to 2:8. The molar concentration of copper with respect to the whole copper complex composition (the sum of copper contained in the first copper complex and copper contained in the second copper complex) is not particularly limited, but is preferably in a range from 0.5 M (mol/L) to 3.0 M (mol/L), for example.

The metal complex composition may further include a solvent that may dissolve the metal complex contained in the metal complex composition. Examples of such a solvent include alcohol-based solvents such as methanol, ethanol, aminoethanol and the like, ketone-based solvents such as cyclohexanone, amide-based solvents such as dimethyl formamide, terpene-based solvents such as terpineol, esterbased solvents and the like. The solvent may be one type among the solvents described above, or a combination of two or more types thereof. The metal complex composition may contain additives other than the metal complex and the medium as necessary. Examples of the additives include a viscosity regulator, a pH regulator and the like.

A laser used for laser irradiation is not particularly limited as long as it causes the decomposition of the metal complex contained in the metal complex composition and the deposition of metal. From the perspective of achieving favorable deposition of metal nanoparticles in the atmosphere, the laser is preferably an infrared laser or near infrared laser, and more preferably an $CO_2$ laser or an Er laser. Laser irradiation may be performed evenly on all of the metal complex compositions, or may be performed in a patterned form as necessary. There may be included a step of removing a composition layer other than a portion thereof where the metal nanoparticles are deposited by laser irradiation. For example, an unwanted metal complex composition may be removed by using a solvent capable of dissolving the metal complex contained in the metal complex composition.

From the metal complex composition transferred onto the electrode 15, the metal is deposited by laser irradiation. Specifically, an irradiated portion is instantaneously heated by laser irradiation; due to this heat, the ligand of the metal complex is decomposed into $CO_2$, CO and $H_2O$, and removed from the metal complex composition in the form of gas. The decomposition of the ligand causes the metal ions forming the metal complex to be reduced, and the metal nanoparticles are deposited. As a result, metal nanoparticles with high purity having high metal concentration are obtained.

A plurality of the metal nanoparticles produced by deposition are melted and grown together in a laser irradiation region. A reaction in which the metal nanoparticles are deposited from the metal complex progresses in a very short time. That is, significantly small size metal nanoparticles are deposited before the metal complex reacts with oxygen in the atmosphere. Accordingly, it is assumed that the metal nanoparticles can be formed favorably from the metal complex composition because of being unlikely to be affected by oxidation even in the atmosphere. The deposited metal nanoparticles are melted at a temperature lower than the melting point of the metal, and therefore the metal nanoparticles may be deposited with low energy. Since the metal complex composition is in a state in which the metal complex is dissolved, problems such as aggregation, oxidation and the like are unlikely to occur and preservation stability is excellent compared to a material using metal particles.

The average particle size (median size, D50) of the metal nanoparticles deposited is not particularly limited, but is preferably in a range from 0.3 nm to 100 nm, more preferably in a range from 0.3 nm to 50 nm, and further more preferably in a range from 0.3 nm to 10 nm. When the average particle size of the metal nanoparticles is in a range from 0.5 nm to 100 nm, problems such as aggregation, oxidation and the like are unlikely to occur, and the joining portion 13 formed evenly with high purity is obtained after thermal fusion. The average particle size of the metal nanoparticles is a value determined by the number average; for example, particle sizes of 100 metal nanoparticles optionally selected from an image captured using a transmission electron microscope are measured, and then the average particle size of the metal nanoparticles can be determined from the average value of the measured particle sizes.

As described above, the copper complex composition is preferably a composition including the first copper complex and the second copper complex. The second copper complex has a lower decomposition temperature than the first copper complex and is more easily decomposed than the first copper complex. Thus, it is assumed that the deposition of copper from the second copper complex occurs earlier to form a nucleus, then the growth of copper nanoparticles based on the nucleus is promoted by the copper deposited from the first copper complex. The copper nanoparticles formed from the copper complex composition have surface smoothness superior to that of the copper nanoparticles formed using a composition including only the first copper complex. Because of this, the copper nanoparticles deposited from the copper complex composition may be formed more densely on the electrode 15.

The metal nanoparticles deposited on the electrode 15 are thermally fused. With this, the joining portion 13 is formed. The joining portion 13 joins the terminal 14 and the electrode 15. Thus, the semiconductor element 11 is mounted on the substrate 12. Since the plurality of joining portions 13 are formed at a time using the microcontact printing method, the semiconductor elements 11 may be efficiently and precisely mounted on the substrate 12.

The mounted structure 10 of the present disclosure may be preferably used, for example, as an optical component such as an LED (including an LED display), a display element for head-up display, a backlight of a liquid crystal display or the like, lighting, a visible light communication device or the like. The semiconductor elements 11 can be efficiently and precisely mounted on the substrate 12, and therefore the mounted structure 10 may be preferably used as a micro LED, which is a specially miniaturized device, or the like. Examples of the micro LED include a device in which the length of the longest line among the lines connecting any two points on the outer periphery of the LED element in a plan view (for example, the length of the diameter in a case of a circular shape) is 100 $\mu$m or less. A mold used in the microcontact printing method and a master mold for forming the mold are described below.

Master Mold

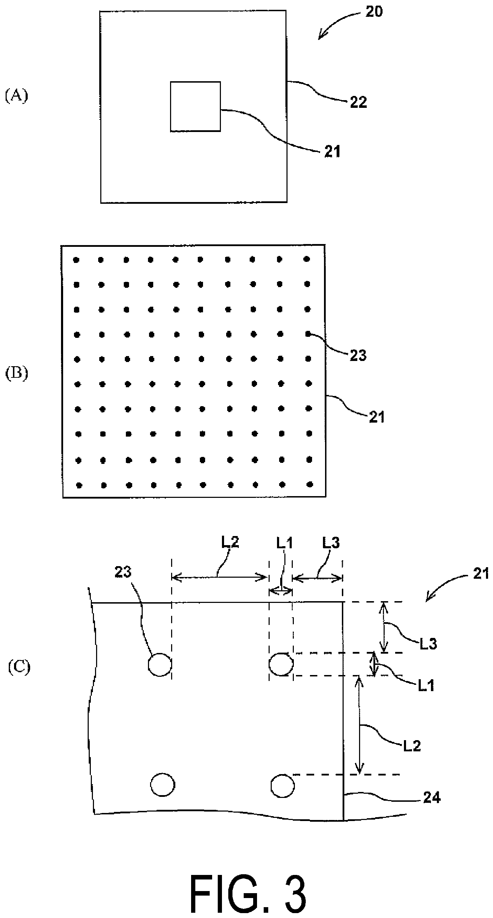

FIG. 3(A) is a plan view of a master mold 20, FIG. 3(B) is a plan view in which a transfer portion 21, which is part of FIG. 3(A), is enlarged and illustrated, and FIG. 3(C) is a plan view in which part of the transfer portion 21 of FIG. 3(B) is further enlarged and illustrated. The master mold 20 is a mold for forming the mold to be used in the microcontact printing method. A pattern shape of an inverted recess-protrusion shape for imparting a desired shape to the mold is imparted to the master mold 20; the pattern shape of the inverted recess-protrusion shape (an inverted shape of the desired mold) corresponds to the desired shape of the mold. The master mold 20 is a structure in which fine shapes of recesses and protrusions are formed on a surface of Si, quartz, metal or the like, and this structure is very expensive and is also referred to as a master. A mold is formed based on the expensive master mold and the pattern formation is carried out by the microcontact printing method using the aboveformed mold, and thus the costs may be reduced significantly.

As illustrated in FIG. 3(A), the master mold 20 includes the transfer portion 21 and a peripheral portion 22. The outer shape of each of the transfer portion 21 and the peripheral portion 22 is rectangular in a plan view, and the peripheral portion 22 surrounds the transfer portion 21. The length of one side of the master mold 20 (the length of one side of the perimeter of the peripheral portion 22) is preferably in a range from 10 mm to 700 mm, more preferably in a range from 10 mm to 150 mm, and further more preferably in a range from 10 mm to 100 mm. The length of one side of the transfer portion 21 is preferably in a range from 10 mm to 600 mm, more preferably in a range from 10 mm to 100 mm, and further more preferably in a range from 10 mm to 50 mm. The shape of each of the transfer portion 21 and the peripheral portion 22 is not limited to a rectangular shape, and other shapes such as a polygonal shape, a circular shape, an elliptical shape and the like may be employed in accordance with the specifications.

As illustrated in FIGS. 3(B) and 3(C), the transfer portion 21 has a recess-protrusion shape on the surface thereof. The transfer portion 21 includes a plurality of recesses 23 formed being separated from each other by a predetermined interval, for example. The recess 23 has a shape recessed in a columnar shape from the surface of the transfer portion 21 to the interior thereof, for example. The shape of the recess 23 is not limited to a columnar shape, and a polygonal prism shape or the like may be employed in accordance with the specifications. The side of the recess 23 recessed to the interior may be formed in a planar shape, or may be formed in a three-dimensional shape, for example, in a hemispherical shape.

When the recess 23 is formed in a columnar shape, a diameter (L1) of the recess 23 in a plan view is preferably 100 $\mu$m or less, more preferably 50 $\mu$m or less, and further more preferably 10 $\mu$m or less. The depth of the recess 23 is preferably 200 $\mu$m or less, more preferably 100 $\mu$m or less, and further more preferably 20 $\mu$m or less.

An interval (L2) between the recesses 23 of the transfer portion 21 is designed in accordance with the layout of each color of the semiconductor elements 11 (111, 112, 113). The interval between the recesses 23 of the transfer portion 21 may be changed as appropriate in accordance with the specifications of the mounted structure 10. For example, when the master mold 20 and the substrate 12 are overlapped each other, the recesses 23 are formed at positions overlapping all of the electrodes 15 on the substrate 12 or at positions overlapping at least some of the electrodes 15. Here, in the case where the metal complex composition is transferred onto the terminal 14 on the semiconductor element 11 side, when the master mold 20 and the semiconductor elements 11 are overlapped each other, the recesses 23 are formed at positions overlapping all of the terminals 14 on the semiconductor elements 11 or at positions overlapping at least some of the terminals 14. Since the plurality of semiconductor elements 11 are present, it is preferable to treat them in such a manner that the plurality of semiconductor elements 11 are loaded on a chip board, for example.

A shortest distance (L3) of the recess 23 from an edge 24 of the transfer portion 21 is preferably 100 $\mu$m or less, preferably 30 $\mu$m or less, and more preferably 10 $\mu$m or less.

Mold

The mold of the present disclosure (hereinafter, also referred to simply as the mold) is made of a cured product or a solidified product of a resin composition (hereinafter, also referred to as a mold-forming resin composition) that forms a mold. The mold is, for example, a film made of a cured product or a solidified product of a resin composition that forms a mold. The mold may be a structure in which a cured product or a solidified product of the mold-forming resin composition is laminated on a base member. A mold containing a fibrous core material may be cited as an example. The base member includes the fibrous core material, and supports a cured product or a solidified product of the mold-forming resin composition.

The cured product or the solidified product of the mold-forming resin composition has a recess-protrusion shape on the surface thereof. The master mold 20 imparts, to the mold, a pattern shape of an inverted recess-protrusion shape corresponding to the shape of the master mold 20. At a location in the mold corresponding to the transfer portion 21 of the master mold 20, a plurality of the protrusions are formed at the locations corresponding to the plurality of recesses 23. The mold-forming resin composition includes resin and a curable composition for forming a mold.

It is preferable that the mold use a mold including a film or a fibrous core material, a linear expansion coefficient of the mold being 200 ppm/K or less and a size of the mold being unchanged before and after being used repeatedly using a solvent. The linear expansion coefficient of the mold is more preferably 100 ppm/K or less, and further more preferably 50 ppm/K or less. When the linear expansion coefficient of the mold is 200 ppm/K or less, a change in volume due to heat of the mold is small. As a result, deformation of the mold due to heat or the like generated by friction is suppressed, and more precise transfer may be carried out when used in the microcontact printing method. When the size of the mold does not change before and after the mold being used repeatedly using a solvent, a change in volume of the mold caused by the solvent is small. Therefore, the deformation of the mold due to the solvent contained in ink is suppressed, and thus more precise transfer may be carried out when the mold is used in the microcontact printing method. The value of the change in size before and after the mold being used repeatedly using a solvent is obtained by comparing the dimensions of the initial mold with the dimensions of the mold after being used repeatedly using the solvent. As the dimensions of the mold after being used repeatedly using the solvent, for example, the dimensions of a mold that is impregnated with the solvent for one hour at room temperature and then is subjected to drying under reduced pressure (10 Pa, 80°C, two hours) may be tentatively used.

Examples of the mold including the fibrous core material include a mold in which there is laminated a mold part where a pattern shape of a recess-protrusion shape is imparted onto the fibrous core material hardened with resin similar to the mold. Examples of the fibrous core material include fabric including a material having low elasticity. Specific examples thereof include nonwoven fabric made of cellulose, cotton or the like, and woven fabric such as glass cloth. By using a mold including a fibrous core material, the mold is strengthened by the fibrous core material, and stable transfer properties may be obtained without being affected by a tensile force at the time of transfer. Furthermore, since the fibrous core material suppresses the volume change due to heat and the swelling due to the solvent, the deformation of the mold itself may be suppressed.

Examples of the resin for forming the above-discussed mold include polysiloxane (dimethylpolysiloxane or the like) as a silicone-based resin, a fluorine-based resin, polyolefin-based resin (polyethylene, polypropylene, polycyclic olefin, or the like), polyethersulfone-based resin, polycarbonate-based resin, polyester-based resin (polyarylate, polyethylene terephthalate, polyethylene naphthalate, or the like), polyamide-based resin, polymethyl methacrylate and the like.

Among the above resins, polysiloxane is particularly preferred. In the curing of the mold-forming resin composition, for example, a three-dimensional crosslinking reaction by hydrosilylation to an unsaturated double bond, a radical polymerization, an epoxy reaction, or the like may be used. Examples of the curable composition include such as polysiloxane containing an epoxy compound and the like. When polysiloxane is used as the resin, the compatibility with a curable composition such as an epoxy compound is excellent, and the contact angle is likely to be small. In addition, when polysiloxane is used as the above-discussed resin and curable composition, the obtained mold is excellent in flexibility, and thus a protruding portion of the mold may extend flexibly along other contacting objects such as a flat plate and may be in contact with the contacting objects when used in the microcontact printing method. As a result, the ink applied to the flat plate and the like may be adsorbed onto the protruding portion of the mold without nonuniformity. Since the mold is excellent in releasability and flexibility, the mold may be more easily taken out from the master mold 20.

In addition to the above-described components, other components such as a release agent may be added to the mold-forming resin composition as needed. For example, an organic solvent may be added to adjust the viscosity. Examples of the organic solvent include a saturated or unsaturated hydrocarbon solvent such as pentane, hexane, heptane, octane, petroleum ether or the like; an aromatic hydrocarbon-based solvent such as benzene, toluene, xylene or the like; ketone such as acetone, methyl ethyl ketone, methyl isobutyl ketone, methyl n-amyl ketone, cyclohexanone or the like; alcohol such as methanol, ethanol, n-butanol or the like; and ether such as 1,2-dimethoxyethane, tetrahydrofuran, dioxane or the like. One of these can be used alone or two or more in combination. It is preferable that the viscosity of the mold-forming resin composition (at 25°C) be adjusted to be approximately in a range from 1 to 100 mPa·s, for example, from the perspective of application properties. The viscosity of the mold-forming resin composition may be measured using a digital viscometer (model No. "DVU-EII", available from TOKIMEC INC.) under the conditions of rotor: standard 1°34' x R24, temperature: 25°C, and rotation speed: from 0.5 to 10 rpm. An example of a method for forming a mold is described below.

Method for Forming Mold

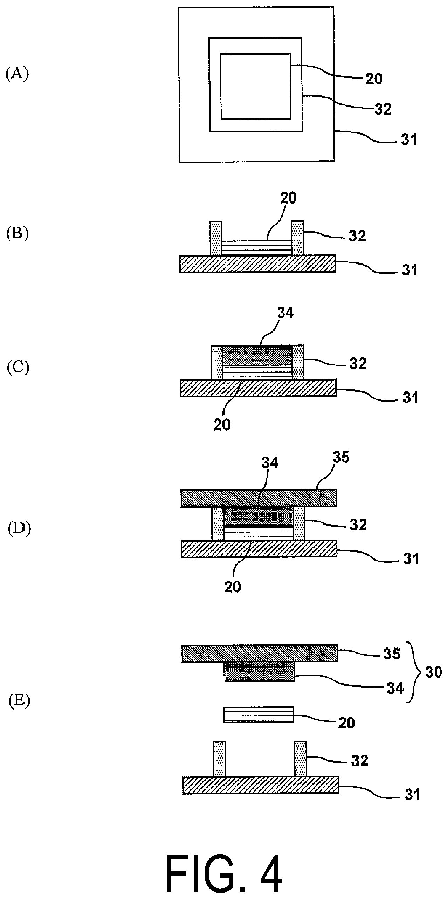

FIGS. 4(A) to 4(E) are schematic diagrams illustrating an example of a method for forming a mold. FIG. 4(A) is a schematic plan view, and FIG. 4(B) is a schematic cross-sectional view of FIG. 4(A). First, as illustrated in FIG. 4(A) and FIG. 4(B), a mold set in which the master mold 20 is set is prepared. Specifically, the master mold 20 and a frame 32 are disposed on a plate 31. In this case, the master mold 20, the plate 31, and the frame 32 each have a square shape in a plan view, but the square shape is an example and the shape thereof is not limited to the square shape.

The frame 32 is formed in a shape surrounding the master mold 20 in a plan view. The length of each side on the inner side of the frame 32 is the same as the length of each side of the master mold 20. In other words, in a case where the master mold 20 is a square with a side of 20 mm in a plan view, the length of each side on the inner side of the frame 32 is 20 mm. With this, the periphery in a horizontal direction of the master mold 20 is fitted into the frame 32. It is preferable for the thickness in the horizontal direction of the frame 32 in a plan view to be 0.5 mm or greater, preferable to be 1 mm or greater, and more preferable to be 10 mm or greater. The thickness in a vertical direction of the frame 32 is preferably a length obtained by adding a desired mold thickness to the thickness in a vertical direction of the master mold 20. As a result, by filling the inner side of the frame 32 with a mold-forming resin composition 34 up to the edge on the upper side thereof, the mold having the desired thickness is obtained. The plate 31 is preferably formed in a flat plate shape, and is provided with a plane direction being level. This makes it possible to obtain the mold in which unwanted nonuniformity in thickness in the horizontal direction is suppressed.

The material of the plate 31 is preferably excellent in heat resistance, and examples thereof include an inorganic material such as glass, silicon or the like; resin such as a cycloolefin-based polymer, polycarbonate, polypropylene, polyethylene, epoxy or the like; metal; and a combination of these materials or the like. When the plate 31 has superior heat resistance, deformation thereof is suppressed when the mold is cured by heat, and the mold in which the recesses and protrusions are precisely transferred from the master mold 20 is obtained. The material of the frame 32 preferably has heat resistance and chemical resistance, and examples thereof include fluorine resins such as Teflon (trademark), cycloolefin-based polymers and the like. When the frame 32 has heat resistance, deformation of the frame 32 is suppressed when the mold is cured by heat. When the frame 32 has chemical resistance, deformation of the frame 32 caused by the resin forming the mold is suppressed. Thus, the mold on which the recesses and protrusions of the master mold 20 are precisely transferred is obtained. The surface of the frame 32 may be subjected to mold release processing with a fluorine-based silane coupling agent or the like as necessary.

Subsequently, as illustrated in FIG. 4(C), the mold-forming resin composition 34 described above is fed into a space surrounded by the frame 32 on the master mold 20 of the mold set. The mold-forming resin composition 34 is filled in the space surrounded by the master mold 20 and the frame 32.

Further, the mold-forming resin composition 34 having been filled is preferably defoamed by a defoaming process. The defoaming may be carried out by a known or commonly used defoaming method. In particular, defoaming by decompression (decompression degassing, vacuum degassing) is preferred. The decompression degassing may be carried out, for example, by statically setting the mold set filled with the mold-forming resin composition 34 under a pressure of 0.1 kPa to 20 kPa for 1 to 10 minutes. As a result, bubbles within the mold-forming resin composition 34 are discharged to the outside. Thus, the bubbles adsorbed on the recesses and protrusions of the master mold 20, for example, may be eliminated, and the mold on which the recesses and protrusions of the master mold 20 are precisely transferred may be obtained.

Subsequently, as necessary, a base member 35 is overlaid to be in close contact to the mold-forming resin composition 34 having been filled, as illustrated in FIG. 4(D). The mold-forming resin composition 34 is sandwiched between the master mold 20 and the base member 35, and the base member 35 may be a mold including the fibrous core material described above. The mold-forming resin composition 34 is likely to be integrated with the base member 35 including the fibrous core material when being cured. After the base member 35 is overlaid on the mold-forming resin composition 34, the laminated members, that is, the plate 31, the master mold 20, the mold-forming resin composition 34, and the base member 35 may be pressed in a lamination direction. Consequently, the adhesion of each member is increased, and a variation in thickness in the lamination direction may be prevented. The pressure during pressing is, for example, from 0.01 to 100 MPa.

Subsequently, the mold-forming resin composition 34 laminated with the plate 31, the master mold 20, and the base member 35 is cured through a curing process. In the curing process, the mold-forming resin composition 34 may be cured by conducting a polymerization reaction of a curable compound (particularly, a cationcurable compound) contained in the mold-forming resin composition 34. The curing method may be appropriately selected from known or commonly used methods. The curing method is not particularly limited, and examples thereof include a method of heating and/or a method of irradiation with active energy rays.

Heating is preferred as the curing method. In the case of heating, it is unnecessary to transmit light for irradiation to the mold-forming resin composition 34, and thus other members surrounding the mold-forming resin composition 34 are not required to have light-transmissive properties. As for the heating conditions, the temperature of heating is preferably 80°C or higher, more preferably 100°C or higher, and further more preferably 150°C or higher. When the temperature is 80°C or higher, the mold-forming resin composition 34 is sufficiently cured. The curing time is preferably 15 minutes or longer, more preferably 30 minutes or longer, and further more preferably 90 minutes or longer. When the curing time is 15 minutes or longer, the mold-forming resin composition 34 is sufficiently cured. The mold-forming resin composition 34 is integrated with the base member 35 when being cured. As a result, the mold 30, in which the mold-forming resin composition 34 and the base member 35 are integrated, is formed.

In a case where curing is carried out by the method of irradiation with active energy rays, any of infrared rays, visible rays, ultraviolet rays, X-rays, electron beams, α-rays, β-rays, γ-rays and the like, for example, may be used as the active energy rays. Among these, ultraviolet rays are preferred in terms of excellent handling. A highpressure mercury lamp, ultra-high pressure mercury lamp, carbon arc lamp, xenon lamp, metal halide lamp or the like is used as the light source when irradiation with ultraviolet light is performed. The irradiation time depends on the type of the light source, the distance between the light source and the coated surface, and other conditions, but is several tens of seconds at the longest. The illuminance is, for example, approximately 5 to 200 mW/cm$^2$. After the irradiation with the active energy ray, heating (post curing) may be performed as necessary to promote the curing.

After the curing process, the mold 30 having been formed may be taken out by being removed from the plate 31, the frame 32, and the master mold 20, as illustrated in FIG. 4(E). Thus, the mold 30 is obtained.

When the mold is a film formed of a cured product of the mold-forming resin composition 34, a member similar to the plate 31 is used in place of the base member 35 in the above-discussed mold forming method. After the mold-forming resin composition 34 is cured, the cured mold-forming resin composition 34 may be taken out by being removed from the plate 31, the frame 32, the master mold 20, and the member similar to the plate 31. With this, the mold that is a film formed of a cured product of the mold-forming resin composition 34 is obtained.


Transfer Method by Microcontact Printing Method

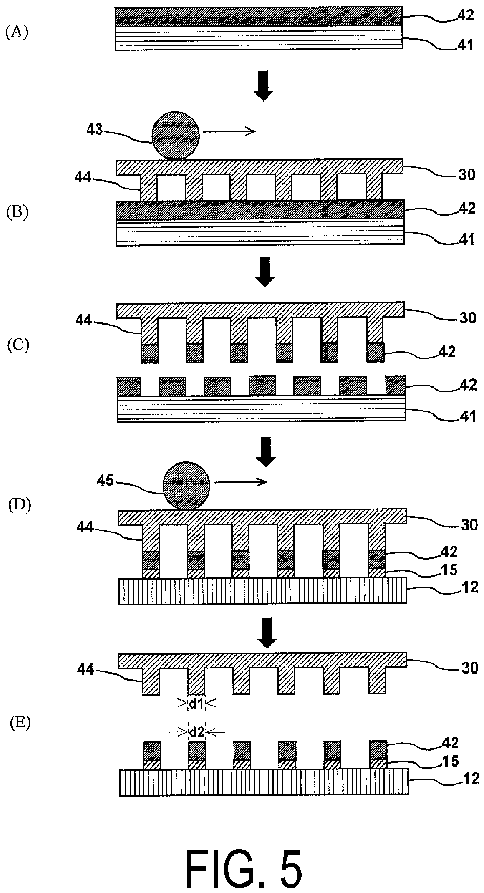

FIGS. 5(A) to 5(E) are schematic diagrams illustrating an example of a transfer method by a microcontact printing method. The transfer method is a letterpress printing scheme using a mold. The description thereof will be given below with reference to FIGS. 5(A) to 5(E).

First, as illustrated in FIG. 5(A), a metal complex composition 42 containing the above-described metal complex (hereinafter, also referred to as the metal complex composition 42) is evenly applied on a flat plate 41. It is preferable that the flat plate 41 have a smooth surface, and be unlikely to deform due to its high rigidity. Examples of a material of the flat plate 41 include glass; silicon; resin such as polycarbonate, polypropylene, polyethylene or the like; a metal; and a combination of these materials or the like.

As an application method of the metal complex composition 42, a known or commonly used method may be used. For example, a spray method, a spin coating method, a screen printing method or the like may be used. The thickness of a coating film of the metal complex composition 42 is, for example, preferably in a range from 0.5 μm to 20 μm, more preferably in a range from 0.5 μm to 10 μm, and further more preferably in a range from 0.5 μm to 5 μm. In the case where the coating film thickness of the metal complex composition 42 is in the range form 0.5 μm to 5 μm, the metal complex composition 42 contains a suitable amount of metal complex, thereby making it possible to sufficiently join the semiconductor element 11 to the substrate 12 at the time of thermal fusion.

Subsequently, as illustrated in FIG. 5(B), the mold 30 is pressed against the metal complex composition 42 having been applied. The mold 30 is pressed in such a manner that the side at which a protrusion 44 is present faces the flat plate 41. A pressure is applied as needed from a side opposite to the side where the mold 30 is pressed against the metal complex composition 42 by a roller 43. It is preferable for the pressure to be 1000 Pa or larger, more preferable to be 10000 Pa or larger, and further more preferable to be 100000 Pa or larger. With this, the mold 30 is evenly pressed against the flat plate 41 side without nonuniformity by the roller 43. Accordingly, the metal complex composition 42 can evenly adhere to the protrusion 44 of the mold 30.

As illustrated in FIG. 5(C), the mold 30 is separated from the flat plate 41. At this time, the metal complex composition 42 is separated from the flat plate 41 while being adsorbed on the protrusion 44 of the mold 30.

As illustrated in FIG. 5(D), the mold 30 is pressed against the substrate 12 having the electrode 15. It is preferable that the electrode 15 be disposed at a location facing the protrusion 44 when the substrate 12 faces the mold 30. The electrodes 15 may be disposed at the locations facing all of the protrusions 44, or at the locations facing some of the protrusions 44 as needed.

A side at which the protrusion 44 of the mold 30 is provided and a side at which the electrode 15 of the substrate 12 is provided face each other and are pressed against each other. Thus, the metal complex composition 42 adsorbed onto the protrusion 44 is pressed against the electrode 15 of the substrate 12. A pressure is applied as needed from a side opposite to the side where the mold 30 is pressed against the metal complex composition 42 by a roller 45. It is preferable for the pressure to be 1000 Pa or larger, more preferable to be 10000 Pa or larger, and further more preferable to be 100000 Pa or larger. With this, the mold 30 is evenly pressed against the substrate 12 side without nonuniformity by the roller 45. Accordingly, the metal complex composition 42 can evenly adhere onto the electrode 15 of the substrate 12.

As illustrated in FIG. 5(E), the mold 30 is separated from the substrate 12. At this time, the metal complex composition 42 is separated from the mold 30 while being adsorbed on the electrode 15 of the substrate 12. Thus, the microcontact printing method using the mold 30 may precisely transfer the metal complex composition 42 to a plurality of locations on the electrodes 15 at a time. The metal complex composition 42 may be transferred onto the terminal 14 on the semiconductor element 11 side instead of being transferred onto the electrode 15 on the substrate 12 side. The metal complex composition 42 may be transferred onto both the electrode 15 and the terminal 14. In the following description of the method for mounting the semiconductor element on the substrate, a case in which the metal complex composition 42 is transferred onto the terminal 14 on the semiconductor element 11 side will be explained.

A transfer ratio indicating transfer properties of a transfer pattern obtained by the above transfer method, transfer precision, and positional deviation preferably satisfy the following criteria. Based on the observation results obtained by using an optical microscope, each transfer pattern is evaluated.

The transfer ratio is preferably 98% or greater, more preferably 99% or greater, and most preferably 100%. When the transfer ratio is 98% or greater, the complex composition 42 may be precisely transferred onto a plurality of locations at a time on the electrodes 15. The transfer ratio is calculated by substituting the observation result into Formula (1) given below.

$$\text{Transfer ratio (\%)} = \text{number of dots having been successfully transferred per set of 10} \\ \times \text{10 dots at a central portion of the transfer pattern}/100 \times 100 \qquad \text{Formula (1)}$$

The transfer precision is preferably 50% or greater, more preferably 80% or greater, and most preferably 100%. When the transfer precision is 50% or greater, the metal complex composition 42 may be precisely transferred onto the plurality of locations at a time on the electrodes 15. The transfer precision is calculated by substituting the observation result into Formula (2) given below.

$$\text{Transfer precision (\%)} = \text{transfer pattern diameter/pillar diameter} \times 100 \\ \text{Formula (2)}$$

The transfer pattern diameter is a size of one dot of the transfer pattern formed on a glass substrate. The pillar diameter is a pillar size of each mold used for the transfer. For example, the size of the dot corresponds to d2 in FIG. 5(E), and the pillar size of the mold corresponds to d1 in FIG. 5(E).

The positional deviation is preferably 10 $\mu$m or less, more preferably 6 $\mu$m or less, further more preferably 2 $\mu$m or less, and 0 $\mu$m. That is, a case of no positional deviation is most preferable. When the positional deviation is 10 $\mu$m or less, the metal complex composition 42 may be precisely transferred onto the plurality of locations at a time on the electrodes 15. The positional deviation is calculated by substituting the observation result into Formula (3) given below.

$$\text{Positional deviation} = \text{the center point of the transfer pattern - the center point on the} \\ \text{setting} \quad \text{Formula (3)}$$

The center point of the transfer pattern is the center position of the transferred dot pattern. The center point on the setting is the center position of the dot pattern when the transfer is carried out precisely with no deviation.

That is, in the mounted structure of the present disclosure, the positional deviation between the joining portion 13 and the electrode 15 or terminal 14 is preferably 10 $\mu$m or less, more preferably 6 $\mu$m or less, further more preferably 2 $\mu$m or less, and 0 $\mu$m. That is, a case of no positional deviation is most preferable. The positional deviation is calculated by substituting the observation result into Formula (4) given below.

$$\text{Positional deviation} = \text{electrode or terminal center point - joining portion center point} \\ \text{Formula (4)}$$

Method for Mounting Semiconductor Element on Substrate

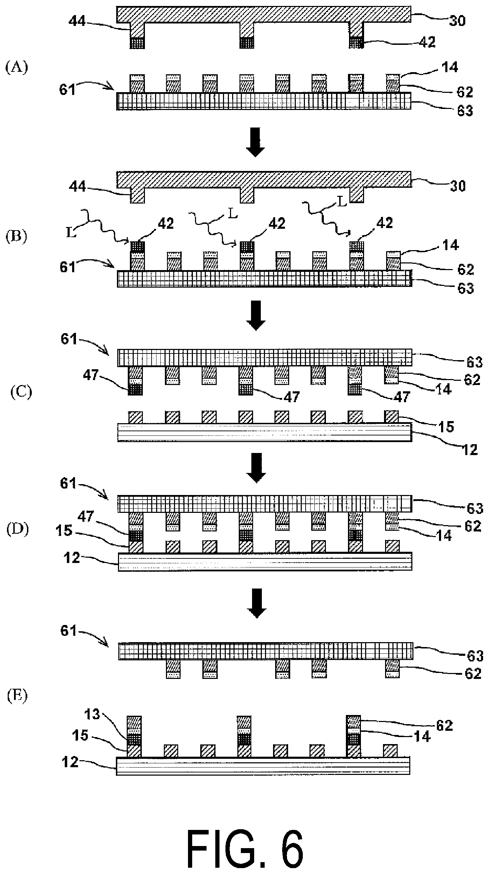

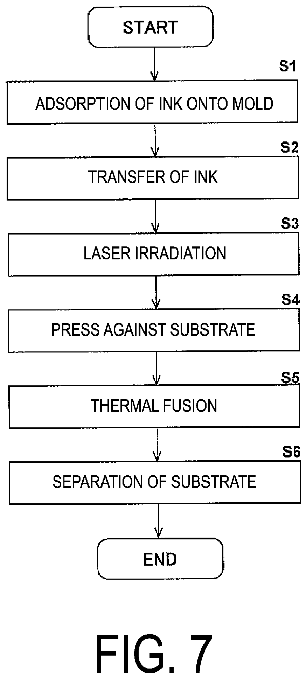

FIGS. 6(A) to 6(E) are schematic diagrams illustrating a method for mounting a semiconductor element onto a substrate according to the present disclosure (hereinafter, also referred to simply as a mounting method). FIG. 7 is a flowchart illustrating the mounting method of the present disclosure. The description thereof will be given below with reference to FIGS. 6(A) to 6(E) and FIG. 7. In the description of the method for mounting a semiconductor element onto a substrate, an LED display is explained as an example of a mounted structure. Here, the microcontact printing method is described with reference to a case of using the transfer method described above, but is not limited thereto. The same contents as those of the transfer method described above are omitted in the description of the mounting method.

The LED display is a device in which the plurality of semiconductor elements 11 are mounted on the substrate 12, as illustrated in FIG. 1(A), for example. In the LED display, the plurality of semiconductor elements 11 include three types of LED elements of R, G, and B. Therefore, it is necessary to mount each LED element at a position determined for each of the types of R, G and B on the substrate 12. The LED elements of three types of R, G, and B need to be mounted on the substrate 12 in an orderly manner with no deviation to prevent the generation of color unevenness or the like.

First, as illustrated in FIG. 6(A), the mold 30 and an LED chip board 61 are prepared. The metal complex composition 42 is evenly adsorbed on the tip of the protrusion 44 of the mold 30. The metal complex composition 42 containing the metal complex is previously adsorbed onto the mold 30 according to the transfer method described above (S1 in FIG. 7). The LED chip board 61 is a member where a plurality of LED elements 62, which are semiconductor elements, are loaded on a chip board 63. For example, the plurality of LED elements 62 are the LED elements of R among R, G, and B. The LED element 62 includes the terminal 14. The terminal 14 is disposed on the LED element 62 at a side in an opposite direction with respect to a side connected to the chip board 63.

The protrusion 44 of the mold 30, when overlaid on the mold 30, overlaps some of the plurality of LED elements 62 of the LED chip board 61 in a plan view. In a case where three types of LED elements are required as in the LED display, the protrusions 44 are preferably formed to overlap only the LED elements 62 at the locations where the LED elements of R are required. With this, when the mold 30 is pressed against the LED chip board 61, the protrusions 44 may be in contact with the locations where the LED elements of R are required. Thereafter, the mold 30 is separated from the LED chip board 61.

As illustrated in FIG. 6(B), the metal complex composition 42 adsorbed on the tip of the protrusion 44 is transferred onto the terminal 14 of the LED element 62 in contact with the metal complex composition 42 (S2 in FIG. 7). In this manner, the mounting method may precisely transfer the metal complex composition 42 onto a plurality of locations at a time.

Subsequently, the metal complex composition 42 transferred onto the terminal 14 is irradiated with a laser L (S3 in FIG. 7). It is sufficient that at least the metal complex composition 42 is irradiated with the laser L, and it is unnecessary for the entire chip board 63 to be irradiated with the laser. Further, it is preferable that all of the metal complex compositions 42 be evenly irradiated with the laser. This causes metal nanoparticles to be evenly deposited from the metal complex composition 42 on the terminal 14. A mass containing the metal nanoparticles deposited from the metal complex composition 42 is referred to as a metal nanoparticle group 47. That is, the metal complex composition 42 changes to the metal nanoparticle group 47 by laser irradiation. Heating (pre-baking) may be performed before laser irradiation as needed. The heating before laser irradiation may facilitate an increase of the deposition speed of the metal nanoparticles within the metal complex composition 42.

Subsequently, as illustrated in FIG. 6(C), the substrate 12 is prepared. As described above, the plurality of electrodes 15 are formed on the surface of the substrate 12. The electrodes 15 are preferably formed at the locations corresponding to at least the three types of LED elements of R, G, and B.

As illustrated in FIG. 6(D), the LED chip board 61 is pressed against the substrate 12 including the electrodes 15 (S4 in FIG. 7). With this, the plurality of LED elements 62 at the locations where the metal nanoparticle group 47 is formed are in contact with the electrodes 15 at the corresponding locations. At this time, the terminal 14 on the LED element 62 is brought into contact with the electrode 15 on the substrate 12 via the metal nanoparticle group 47. In other words, the terminal 14 and the electrode 15 are in contact with each other while pinching the metal nanoparticle group 47 containing the metal nanoparticles therebetween.

Heating is performed while the terminal 14 and the electrode 15 are in contact with each other via the metal nanoparticle group 47 (S5 in FIG. 7). The metal nanoparticles within the metal nanoparticle group 47 are thermally fused by heating, thereby forming the joining portion 13. As described above, the joining portion 13 may be mixed with part of the terminal 14 and electrode 15 dissolved by the thermal fusion, and may be integrated with the terminal 14 and electrode 15. Thus, the terminal 14 and the electrode 15 are joined more firmly.

Subsequently, as illustrated in FIG. 6(E), the LED chip board 61 is separated from the substrate 12 (S6 in FIG. 7). With this, the plurality of LED elements 62, which are the LED elements of R, are precisely mounted on the substrate 12 at a time. By using a similar method, the LED elements of G or B may be mounted on the substrate 12. Thus, in the LED display, the LED elements of the three types of R, G, and B may be mounted on the substrate 12 at a time for each type. Accordingly, the time and manpower may be significantly reduced compared to a case in which the LED elements 62 are mounted one by one on the substrate 12.

Examples

Hereinafter, the present disclosure will be described more specifically with reference to examples, but the present disclosure is not limited to these examples, and modifications and improvements within the scope of achieving the object of the present disclosure are encompassed by the present disclosure. Molds used in Example 1, Transfer Examples 1 to 3, and Reference Example 1 were prepared by the methods described in Production Examples 1 to 3 given below.

Production Example 1

Production Example of Mold (A)

In Production Example 1, a case in which the mold is a film formed of a cured product of a resin composition is exemplified.

Liquid polysiloxane composition 1 was prepared by mixing a liquid polysiloxane (PDMS) ("SIM-260" available from Shin-Etsu Chemical Co., ltd.) and a curing agent ("CAT 260" available from Shin-Etsu Chemical Co., ltd.) in a ratio (weight ratio) of liquid polysiloxane/curing agent = 10/1. A master mold (made of silicon, a square with a side of 20 mm in a plan view, a transfer portion being a square with a side of 5 mm in the plan view, 100 x 100 holes, the hole size being 10 $\mu$m, the hole depth being 10 $\mu$m, the shortest distance between holes being 10 $\mu$m, the shortest distance from an edge for holes in the transfer portion being 20 $\mu$m) imparted with a pattern of recesses and protrusions and having a thickness of 1 mm in the lamination direction was fixed onto a glass substrate.

Subsequently, a frame (made of Teflon (trademark), the inner size being a square with a side of 20 mm in a plan view, the thickness in the lamination direction being 3 mm) was fixed onto the glass substrate to surround the master mold. The prepared liquid polysiloxane composition 1 was fed into a space surrounded by the master mold and the frame. The fed liquid polysiloxane composition 1 was degassed under reduced pressure (pressure 10 kPa) for 30 minutes, and then a glass substrate was pasted on the upper portion of the liquid polysiloxane composition 1 while preventing bubbles from entering into a gap between the glass substrate and the liquid polysiloxane composition 1. After having cured the liquid polysiloxane composition 1 at 150°C for two hours, the aforementioned glass substrate, frame, and master mold were separated to obtain a mold (A). A film-shaped mold (A) with a film thickness of 2 mm was obtained, where a pillar-shaped pattern (size of a protrusion pattern: 10 $\mu$m, height of a protrusion: 10 $\mu$m) was formed on the surface of the mold.

Production Example 2

Production Example of Mold (B)

In Production Example 2, a case where the mold is a fibrous core materialcontaining mold will be described. A cellulose nonwoven fabric (40 mm square) was prepared as the fibrous core material. The same description as that in Production Example 1 is omitted in the description of Production Example 2.

Liquid polysiloxane composition 2 was prepared by mixing a liquid polysiloxane (PDMS) ("SIM-260" available from Shin-Etsu Chemical Co., ltd.), a curing agent ("CAT 260" available from Shin-Etsu Chemical Co., ltd.), and acetone in a ratio (weight ratio) of liquid polysiloxane/curing agent/acetone = 10/1/3. A gadget in which a cellulose nonwoven fabric is set stretching over an aluminum-made frame having an opening of 30 mm square was put into the liquid polysiloxane composition 2 stored in a tray, and was left therein for 30 minutes to cause the cellulose nonwoven fabric to be impregnated with the liquid polysiloxane composition 2. After the aluminum-made frame was pulled up and an excess of the liquid polysiloxane composition 2 was wiped off with a squeegee, the aluminum-made frame was left still for 24 hours at 23°C in a state of being vertically suspended. Thereafter, the liquid polysiloxane composition 2 was cured by heating at 150°C for two hours to fabricate a sheet-shaped mold base material (thickness in the lamination direction: 0.5 mm).

Similar to Production Example 1, a master mold was fixed on a glass substrate, and a frame (made of Teflon (trademark), the inner size being a square with a side of 20 mm in a plan view, the thickness in the lamination direction being 2.0 mm) was fixed onto the glass substrate to surround the master mold. The prepared liquid polysiloxane composition 1 was fed into a space surrounded by the master mold and the frame. After degassing under reduced pressure, the fabricated sheet-shaped mold base material was pasted on the upper portion of the liquid polysiloxane composition 1 while preventing bubbles from entering into a gap between the sheet-shaped mold base material and the liquid polysiloxane composition 1. After having cured the liquid polysiloxane composition 1, the glass substrate, the frame, and the master mold were separated to obtain a mold (B) (the thickness in the lamination direction (a location where the sheet-shaped mold base material and the cured product of the liquid polysiloxane composition 1 were laminated):

1.5 mm).

Production Example 3

Production Example of Mold (C)

In Production Example 3, a mold used in Reference Example 1 is described. The same description as that in Production Example 1 is omitted in the description of Production Example 3.

An amount of 10 g of cycloolefin copolymer TOPAS (available from Polyplastics Co., Ltd.) was dissolved in 100 ml of a toluene solvent. The prepared toluene solution was spin-coated on a quartz substrate, and then was subjected to heating for 10 minutes on a 100°C hot plate to remove the solvent. Thus, a coating film with a thickness of 2 to 10 $\mu$m was formed in a dry state. Subsequently, the above-discussed master mold was subjected to pressure transfer at 160°C using an imprint device (NM-0401, available from MEISYO KIKO Co., Ltd.). A mold (C) was obtained by mold releasing from the master mold at room temperature.

Preparation Examples, Transfer Examples 1 and 2, and Reference Example 1 are described below. In Preparation Examples, the preparation of a copper complex composition is described. The mold (A) obtained in Production Example 1 was used in Transfer Example 1, the mold (B) obtained in Production Example 2 was used in Transfer Example 2, and the mold (C) obtained in Production Example 3 was used in Reference Example 1.

Preparation Example 1

Copper Complex Composition A

Glyoxylic acid copper (available from FUJIFILM Wako Pure Chemical Corporation) in an amount of 0.95 g was dissolved in a mixed solution of 1-ml 2-aminoethanol and 2-ml ethanol to prepare a glyoxylic acid copper solution of 1.7 mol/L. Formic acid copper tetrahydrate (available from FUJIFILM Wako Pure Chemical Corporation) in an amount of 1.15 g was dissolved in 3 ml of 40-wt.% methylamine methanol to prepare a methylamine copper complex solution of 1.7 mol/L. A copper complex composition A containing an $\alpha$-keto acid copper complex and methylamine copper complex was prepared by mixing the prepared glyoxylic acid copper solution and methylamine copper complex solution.

Preparation Example 2

Copper Complex Composition B

Glyoxylic acid copper (available from FUJIFILM Wako Pure Chemical Corporation) in an amount of 0.55 g was dissolved in a mixed solution of 1-ml 2-aminoethanol and 2-ml ethanol to prepare a glyoxylic acid copper solution of 1 mol/L. Formic acid copper tetrahydrate (available from FUJIFILM Wako Pure Chemical Corporation) in an amount of 0.65 g was dissolved in 3 ml of 40-wt.% methylamine methanol to prepare a methylamine copper complex solution of 1 mol/L. A copper complex composition B containing an $\alpha$-keto acid copper complex and methylamine copper complex was prepared by mixing the prepared glyoxylic acid copper solution and methylamine copper complex solution.

Transfer Example 1

The prepared copper complex composition A in an amount of 0.1 ml was subjected to spin coating (3000 rpm, 30 seconds) onto slide glass to fabricate a liquid coating film with a film thickness of 0.1 $\mu$m. Subsequently, the mold (A) of Production Example 1 was pressed onto the fabricated liquid coating film. The copper complex composition A attached to a protrusion of the mold (A) was transferred onto a glass substrate. The copper complex composition A transferred onto the glass substrate was heated (pre-baked) for 10 minutes at 80°C. Subsequently, copper nanoparticles were deposited by $CO_2$ laser irradiation (distance between the laser and a composition layer: 145 mm, sweep rate: 20 mm/s, output: 8.0 W) to obtain a transfer pattern (A) containing the copper nanoparticles formed on the glass substrate.

Transfer Example 2

By the same operation as that in Transfer Example 1 except that the mold (B) of Production Example 2 was used, the copper complex composition A was transferred and the copper nanoparticles were deposited, thereby obtaining a transfer pattern (B) containing the copper nanoparticles formed on a glass substrate.

Reference Example 1

By the same operation as that in Transfer Example 1 except that the mold (C) of Production Example 3 was used, the copper complex composition A was transferred and the copper nanoparticles were deposited, thereby obtaining a transfer pattern (C) containing the copper nanoparticles formed on a glass substrate.

Evaluation of Transfer Properties

The transfer patterns (A) to (C) obtained in Transfer Examples 1 and 2 and Reference Example 1 were observed by using an optical microscope (DM4000M, available from Leica Microsystems). The transfer ratio, the transfer precision, and the positional deviation were evaluated based on the observation results of the optical microscope by the following methods.

Transfer Ratio

Each transfer ratio of the obtained transfer pattern was calculated by substituting the observation result into Formula (1) given below.

$$\text{Transfer ratio (\%)} = \text{number of dots having been successfully transferred per set of 10} \times \text{10 dots at a central portion of the transfer pattern/100} \times 100 \qquad \text{Formula (1)}$$

The transfer properties in the transfer ratio (that is, indicating the percentage of successful transfers in 100 pillar patterns) were evaluated by the following evaluation criteria.

Good: 98% $\leq$ transfer ratio: (good transfer properties)
Poor: transfer ratio < 98%: (poor transfer properties)

Transfer Precision

Each transfer precision of the obtained transfer pattern was calculated by substituting the observation result into Formula (2) given below.

$$\text{Transfer precision (\%)} = \text{transfer pattern diameter/pillar diameter} \times 100$$

$$\text{Formula (2)}$$

As the transfer pattern diameter, a size of one dot of the transfer pattern formed on the glass substrate was measured. The pillar diameter is a pillar size of each mold used for the transfer.
The transfer properties in the transfer precision were evaluated by the following evaluation criteria.

Excellent: 80% $\leq$ transfer precision < 105% (excellent transfer properties)
Good: 50% $\leq$ transfer precision < 80% (good transfer properties)
Poor: transfer precision < 50% (poor transfer properties)

Positional Deviation

Each positional deviation of the obtained transfer pattern was calculated by substituting the observation result into Formula (3) given below.

$$\text{Positional deviation} = \text{the center point of the transfer pattern - the center point on the setting} \quad \text{Formula (3)}$$

The center point of the transfer pattern is the center position of the transferred dot pattern. The center point on the setting is the center position of the dot pattern when the transfer is carried out precisely with no deviation.
The transfer properties in the positional deviation were evaluated by the following evaluation criteria.

Excellent: positional deviation ≤ 2 μm (Excellent transfer properties)
Good: 2 μm < positional deviation ≤ 10 μm (good transfer properties)
Poor: 10 μm < positional deviation (poor transfer properties)

The above-described results are summarized in Table 1 given below.

Table 1

Table 1

|  |  | Transfer Example 1 | Transfer Example 2 | Reference Example 1 |
|---|---|---|---|---|
| Mold | (A) | Good | - | - |
|  | (B) | - | Good | - |
|  | (C) | - | - | Good |
| Evaluation of transfer properties | Transfer ratio | Good | Good | Poor |
|  | Transfer precision | Excellent | Excellent | Good |
|  | Positional deviation | Good | Excellent | Good |

The transfer properties of the transfer patterns (A) and (B) obtained in Transfer Examples 1 and 2 were confirmed to be superior in any of the transfer ratio, transfer precision, and positional deviation to the transfer properties of the transfer pattern (C) obtained in Reference Example 1. From this, it was confirmed that the transfer was performed onto the glass substrate in accordance with the protrusion shape of the mold more faithfully in each of the molds produced using the PDMS of Production Examples 1 and 2 than in the mold produced using the cycloolefin copolymer of Production Example 3. It was also confirmed that the transfer properties of the transfer pattern (B) obtained in Transfer Example 2 were more excellent than the transfer properties of the transfer pattern (A) obtained in Transfer Example 1. From this, it was confirmed that mold (B) was reinforced with the cellulose nonwoven fabric and exhibited stable transfer properties without being affected by a tensile force during the transfer.

Example 1

Example of Joining

The prepared copper complex composition B in an amount of 0.1 ml was subjected to spin coating (3000 rpm, 30 seconds) onto slide glass to fabricate a liquid coating film with a film thickness of 1.0 μm. Subsequently, the mold (B) of Production Example 2 was pressed onto the fabricated liquid coating film. The copper complex composition B attached to a protrusion of the mold (B) was transferred onto a smooth copper plate. The copper complex composition B transferred onto the copper plate was heated (pre-baked) for 10 minutes at 80°C. Subsequently, copper nanoparticles were deposited by $CO_2$ laser irradiation (distance between the laser and a composition layer: 145 mm, sweep rate: 20 mm/s, output: 8.0 W) to obtain a transfer pattern containing the copper nanoparticles formed on the copper plate.

Subsequently, the copper plate was set on a glass substrate including a copper bump having the same pattern shape as that of the master mold. At this time, the copper bump on the glass substrate was laminated with an orientation facing the transfer pattern transferred on the copper plate. The laminated glass substrate and copper plate were heated at 200°C for 30 minutes. The copper nanoparticles in the transfer pattern were thermally fused with the copper bump on the glass substrate. This resulted in the copper plate being joined with the copper bump on the glass substrate. The joining state was observed from the glass surface by using an optical microscope (DM4000M, available from Leica Microsystems). From the observation result by the optical microscope, it was confirmed that the copper plate was joined with the copper bump on the glass substrate.

Each of the aspects disclosed herein may be combined with any other feature disclosed herein.

Hereinafter, variations of the invention according to the present disclosure will be described.

[Appendix 1] A mounted structure in which a semiconductor element including a terminal is mounted on a substrate including an electrode, the mounted structure including a joining portion in which the terminal and the electrode are joined opposing each other,

wherein the electrode is a bump of a bulk metal material disposed on the substrate, and
the joining portion is produced by thermally fusing metal nanoparticles, the metal nanoparticles being deposited from a metal complex by laser irradiation, the metal complex having been transferred onto at least one of the electrode or the terminal by using a microcontact printing method.

[Appendix 2] The mounted structure according to Appendix 1, wherein the metal complex includes a copper complex.

[Appendix 3] The mounted structure according to Appendix 2, wherein the copper complex includes a first copper complex formed of a keto acid and a copper ion, and a second copper complex formed of a copper ion and a ligand containing a nitrogen atom.

[Appendix 4] The mounted structure according to Appendix 3, wherein the sum of the contents of the first copper complex and the second copper complex is in a range from 90 wt.% to 5 wt.% (preferably from 80 wt.% to 10 wt.%) of the whole of a composition forming the metal complex.

[Appendix 5] The mounted structure according to Appendix 3 or 4, wherein the molar ratio of the first copper complex and the second copper complex (first copper complex: second copper complex) is in a range from 9:1 to 1:9 (preferably from 8:2 to 2:8).

[Appendix 6] The mounted structure according to any one of Appendices 2 to 5, wherein the molar concentration of copper with respect to the whole composition forming the metal complex is in a range from 0.5 M (mol/L) to 3.0 M (mol/L).

[Appendix 7] The mounted structure according to any one of Appendices 1 to 6, wherein the median size of the metal nanoparticles is in a range from 0.3 nm to 100 nm (preferably from 0.3 nm to 50 nm, more preferably from 0.3 nm to 10 nm).

[Appendix 8] The mounted structure according to any one of Appendices 1 to 7, wherein a mold used in the microcontact printing method contains polysiloxane as a constituent material.

[Appendix 9] The mounted structure according to any one of Appendices 1 to 8, wherein the mold used in the microcontact printing method uses a mold made of a film or a mold containing a fibrous core material (preferably a mold made of polysiloxane containing a fibrous core material), a linear expansion coefficient of the mold being 200 ppm/K or less (preferably 100 ppm/K or less, more preferably 50 ppm/K or less) and a size of the mold being unchanged before and after being used repeatedly using a solvent.

[Appendix 10] The mounted structure according to Appendix 9, wherein the mold containing the fibrous core material is a mold in which a mold portion imparted with a pattern shape of a recess-protrusion shape is laminated on the fibrous core material solidified with resin (preferably with polysiloxane).

[Appendix 11] The mounted structure according to Appendix 10, wherein the fibrous core material solidified with the resin has a structure in which the fibrous core material is impregnated with the resin.

[Appendix 12] The mounted structure according to any one of Appendices 9 to 11, wherein the fibrous core material is nonwoven fabric.

[Appendix 13]

The mounted structure according to any one of Appendices 1 to 12, wherein a positional deviation calculated by Formula (4) given below with respect to the electrode or the terminal and the joining portion is 10 $\mu$m or less (preferably 6 $\mu$m or less, more preferably 2 $\mu$m or less, and further more preferably 0 $\mu$m).

$$\text{Positional deviation} = \text{electrode or terminal center point} - \text{joining portion center point}$$
$$\text{Formula (4)}$$

[Appendix 14] The mounted structure according to any one of Appendices 1 to 13, wherein the laser irradiation is performed using a $CO_2$ laser or an Er laser.

[Appendix 15] The mounted structure according to any one of Appendices 1 to 14, wherein the semiconductor element is an LED element in which a length of the longest line among the lines connecting any two points on an outer periphery of the semiconductor element in a plan view is 100 $\mu$m or less.

[Appendix 16] An LED display including the mounted structure according to any one of Appendices 1 to 15.

[Appendix 17]

A mounting method for mounting a semiconductor element including a terminal onto a substrate including an electrode that is a bump of a bulk metal material disposed on the substrate, the mounting method including:

> transferring a metal complex onto at least one of the electrode or the terminal by using a microcontact printing method,
> depositing metal nanoparticles from the metal complex by laser irradiation, and
> performing thermal fusion in a state in which the terminal and the electrode are in contact with and oppose each other via the deposited metal nanoparticles.

[Appendix 18] The mounting method according to Appendix 17, wherein the metal complex includes a copper complex.

[Appendix 19] The mounting method according to Appendix 18, wherein the metal complex includes a first copper complex formed of a keto acid and a copper ion, and a second copper complex formed of a copper ion and a ligand containing a nitrogen atom.

[Appendix 20] The mounting method according to Appendix 19, wherein the sum of the contents of the first copper complex and the second copper complex is in a range from 90 wt.% to 5 wt.% (preferably from 80 wt.% to 10 wt.%) of the whole of a composition forming the metal complex.

[Appendix 21] The mounting method according to Appendix 19 or 20, wherein the molar ratio of the first copper complex and the second copper complex (first copper complex: second copper complex) is in a range from 9:1 to 1:9 (preferably from 8:2 to 2:8).

[Appendix 22] The mounting method according to any one of Appendices 18 to 21, wherein the molar concentration of copper with respect to the whole composition forming the metal complex is in a range from 0.5 M (mol/L) to 3.0 M (mol/L).

[Appendix 23] The mounting method according to any one of Appendices 17 to 22, wherein the median size of the metal nanoparticles is in a range from 0.3 nm to 100 nm (preferably from 0.3 nm to 50 nm, more preferably from 0.3 nm to 10 nm).

[Appendix 24] The mounting method according to any one of Appendices 17 to 23, wherein the microcontact printing method includes a step of causing a metal complex composition to be adsorbed onto a protrusion included in a mold.

[Appendix 25] The mounting method according to any one of Appendices 17 to 24, wherein the microcontact printing method includes a step of performing the laser irradiation on the metal complex composition adsorbed on the protrusion included in the mold.

[Appendix 26] The mounting method according to Appendix 25, wherein the metal complex composition is heated prior to the laser irradiation.

[Appendix 27] The mounting method according to any one of Appendices 17 to 26, wherein the mold used in the microcontact printing method contains polysiloxane as a constituent material.

[Appendix 28] The mounting method according to any one of Appendices 17 to 27, wherein the mold used in the microcontact printing method uses a mold made of a film or a mold containing a fibrous core material (preferably a mold made of polysiloxane containing a fibrous core material), a linear expansion coefficient of the mold being 200 ppm/K or less (preferably 100 ppm/K or less, more preferably 50 ppm/K or less) and a size of the mold being unchanged before and after being used repeatedly using a solvent.

[Appendix 29] The mounting method according to Appendix 28, wherein the mold containing the fibrous core material is a mold in which a mold portion imparted with a pattern shape of a recess-protrusion shape is laminated on the fibrous core material solidified with resin (preferably with polysiloxane).

[Appendix 30] The mounting method according to Appendix 29, wherein the fibrous core material solidified with the resin has a structure in which the fibrous core material is impregnated with the resin.

[Appendix 31] The mounting method according to any one of Appendices 28 to 30, wherein the fibrous core material is nonwoven fabric.

[Appendix 32] The mounting method according to any one of Appendices 17 to 31, wherein the laser irradiation is performed using a $CO_2$ laser or an Er laser.

[Appendix 33] The mounting method according to any one of Appendices 17 to 32, wherein the semiconductor element is an LED element in which a length of the longest line among the lines connecting any two points on an outer periphery of the semiconductor element in a plan view is 100 $\mu$m or less.

[Appendix 34] The mounting method according to any one of Appendices 17 to 33, wherein the transfer ratio calculated from Formula (1) given below when the metal complex is transferred onto at least one of the electrode or the terminal is 98% or greater (preferably 99% or greater, more preferably 100%).

$$\text{Transfer ratio } (\%) = \text{number of dots having been successfully transferred per set of 10} \times 10 \text{ dots at a central portion of the transfer pattern}/100 \times 100 \qquad \text{Formula (1)}$$

[Appendix 35] The mounting method according to any one of Appendices 17 to 34, wherein the transfer precision calculated from Formula (2) given below when the metal complex is transferred onto at least one of the electrode or the terminal is 50% or greater (preferably 80% or greater, more preferably 100%).

$$\text{Transfer precision } (\%) = \text{transfer pattern diameter/pillar diameter} \times 100$$

$$\text{Formula (2)}$$

The transfer pattern diameter is a size of one dot of the transfer pattern formed on a glass substrate. The pillar diameter is a pillar size of each mold used for the transfer.

[Appendix 36] The mounting method according to any one of Appendices 17 to 35, wherein the positional deviation calculated from Formula (3) given below when the metal complex is transferred onto at least one of the electrode or the terminal is 10 $\mu$m or less (preferably 6 $\mu$m or less, more preferably 2 $\mu$m or less, further more preferably 0 $\mu$m).

$$\text{Positional deviation} = \text{the center point of the transfer pattern - the center point on the}$$

$$\text{setting} \quad \text{Formula (3)}$$

The center point of the transfer pattern is the center position of the transferred dot pattern. The center point on the setting is the center position of the dot pattern when the transfer is carried out precisely with no deviation.

Industrial Applicability

The mounting method of the present disclosure may mount a plurality of semiconductor elements on a substrate at a time efficiently and precisely with little joining deviation. The mounted structure of the present disclosure is a structure in which the semiconductor elements are precisely mounted on the substrate at a time with little joining deviation. Thus, the mounting method and the mounted structure of the present disclosure may be preferably used, for example, as an optical component such as an LED (including an LED display), a display element for head-up display, a backlight of a liquid crystal display or the like, lighting, a visible light communication device or the like. The semiconductor elements 11 can be efficiently and precisely mounted on the substrate, and therefore the mounted structure of the present disclosure may be preferably used as a specially miniaturized device, for example, as a micro LED or the like.

Reference Signs List

10, 101 Mounted structure
11, 111, 112, 113 Semiconductor element
12 Substrate
13 Joining portion
14 Terminal
15 Electrode
20 Master mold
21 Transfer portion
22 Peripheral portion
23 Recess
24 Edge of transfer portion
30 Mold
31 Plate
32 Frame
34 Mold-forming resin composition
35 Base member
41 Flat plate
42 Metal complex composition
43, 45 Roller
44 Protrusion
47 Metal nanoparticle group
61 LED chip board

62 LED element
63 Chip board

**Claims**

1. A mounted structure in which a semiconductor element including a terminal is mounted on a substrate including an electrode, the mounted structure comprising a joining portion in which the terminal and the electrode are joined opposing each other,

   wherein the electrode is a bump of a bulk metal material disposed on the substrate, and
   the joining portion is produced by thermally fusing metal nanoparticles, the metal nanoparticles being deposited from a metal complex by laser irradiation, the metal complex having been transferred onto at least one of the electrode or the terminal by using a microcontact printing method.

2. The mounted structure according to claim 1, wherein the metal complex includes a copper complex formed of a keto acid and a copper ion, and a copper complex formed of a copper ion and a ligand containing a nitrogen atom.

3. The mounted structure according to claim 1 or 2,
   wherein a mold used in the microcontact printing method contains polysiloxane as a constituent material.

4. The mounted structure according to any one of claims 1 to 3,
   wherein the mold used in the microcontact printing method uses a mold made of a film or a mold made of polysiloxane containing a fibrous core material, a linear expansion coefficient of the mold being 200 ppm/K or less and a size of the mold being unchanged before and after being used repeatedly using a solvent.

5. The mounted structure according to any one of claims 1 to 4, wherein the laser irradiation is performed using a $CO_2$ laser or an Er laser.

6. The mounted structure according to any one of claims 1 to 5,
   wherein the semiconductor element is an LED element in which a length of the longest line among lines connecting any two points on an outer periphery of the semiconductor element in a plan view is 100 $\mu$m or less.

7. An LED display comprising the mounted structure according to any one of claims 1 to 6.

8. A mounting method for mounting a semiconductor element including a terminal onto a substrate including an electrode that is a bump of a bulk metal material disposed on the substrate, the mounting method comprising:

   transferring a metal complex onto at least one of the electrode or the terminal by using a microcontact printing method,
   depositing metal nanoparticles from the metal complex by laser irradiation, and
   performing thermal fusion in a state in which the terminal and the electrode are in contact with and oppose each other via the deposited metal nanoparticles.

9. The mounting method according to claim 8, wherein the metal complex includes a copper complex formed of a keto acid and a copper ion, and a copper complex formed of a copper ion and a ligand containing a nitrogen atom.

10. The mounting method according to claim 8 or 9,
    wherein a mold used in the microcontact printing method contains polysiloxane as a constituent material.

11. The mounting method according to any one of claims 8 to 10,
    wherein the mold used in the microcontact printing method uses a mold made of a film or a mold made of polysiloxane containing a fibrous core material, a linear expansion coefficient of the mold being 200 ppm/K or less and a size of the mold being unchanged before and after being used repeatedly using a solvent.

12. The mounting method according to any one of claims 8 to 11, wherein the laser irradiation is performed using a $CO_2$ laser or an Er laser.

**13.** The mounting method according to any one of claims 8 to 12,
wherein the semiconductor element is an LED element in which a length of the longest line among lines connecting any two points on an outer periphery of the semiconductor element in a plan view is 100 $\mu$m or less.

(A)

(B)

# FIG. 1

10

11 (111)
11 (112)
11 (113)

12

(A)

11 (112)

101

11 (111)

11 (113)

12

(B)

# FIG. 2

(A)

20

22

21

(B)

23

21

(C)

L2   L1   L3

23

21

L3

L1

L2

24

# FIG. 3

(A)

(B)

(C)

(D)

(E)

# FIG. 4

(A)

42
41

(B)

43
44
30
42
41

(C)

44
30
42

42
41

(D)

45
44
30
42
15
12

(E)

44
30
d1
d2
42
15
12

# FIG. 5

**FIG. 6**

START

ADSORPTION OF INK ONTO MOLD    S1

TRANSFER OF INK    S2

LASER IRRADIATION    S3

PRESS AGAINST SUBSTRATE    S4

THERMAL FUSION    S5

SEPARATION OF SUBSTRATE    S6

END

FIG. 7

<table>
<tr><td colspan="2" align="center">INTERNATIONAL SEARCH REPORT</td><td colspan="2">International application No.<br>**PCT/JP2021/032305**</td></tr>
</table>

**A.   CLASSIFICATION OF SUBJECT MATTER**

*H01L 23/12*(2006.01)i; *G09F 9/00*(2006.01)i; *G09F 9/33*(2006.01)i; *H05K 3/20*(2006.01)i; *H05K 3/32*(2006.01)i
FI:   H05K3/20 C; G09F9/33; G09F9/00 338; H05K3/32 B; H01L23/12 F

According to International Patent Classification (IPC) or to both national classification and IPC

**B.   FIELDS SEARCHED**

Minimum documentation searched (classification system followed by classification symbols)

H01L23/12; G09F9/00; G09F9/33; H05K3/20; H05K3/32

Documentation searched other than minimum documentation to the extent that such documents are included in the fields searched

Published examined utility model applications of Japan 1922-1996
Published unexamined utility model applications of Japan 1971-2021
Registered utility model specifications of Japan 1996-2021
Published registered utility model applications of Japan 1994-2021

Electronic data base consulted during the international search (name of data base and, where practicable, search terms used)

**C.   DOCUMENTS CONSIDERED TO BE RELEVANT**

| Category* | Citation of document, with indication, where appropriate, of the relevant passages | Relevant to claim No. |
|---|---|---|
| Y | JP 2010-3854 A (SEIKO EPSON CORP.) 07 January 2010 (2010-01-07)<br>paragraphs [0027]-[0121], fig. 6 | 1-13 |
| Y | JP 2010-278228 A (SEIKO EPSON CORP.) 09 December 2010 (2010-12-09)<br>paragraph [0051] | 1-13 |
| Y | WO 2018/212345 A1 (SHIBAURA INSTITUTE OF TECHNOLOGY) 22 November 2018<br>(2018-11-22)<br>paragraphs [0011]-[0031] | 1-13 |
| Y | JP 2004-277868 A (MITSUBISHI PAPER MILLS LTD.) 07 October 2004 (2004-10-07)<br>paragraphs [0012]-[0041] | 1-13 |
| Y | JP 2012-119572 A (SHIMADZU CORP.) 21 June 2012 (2012-06-21)<br>paragraphs [0007], [0038], fig. 4 | 4, 11 |
| A | JP 7-212015 A (MATSUSHITA ELECTRIC INDUSTRIAL CO., LTD.) 11 August 1995<br>(1995-08-11) | 1-13 |

☐ Further documents are listed in the continuation of Box C.    ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **02 November 2021** | **16 November 2021** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

INTERNATIONAL SEARCH REPORT
Information on patent family members

International application No.

**PCT/JP2021/032305**

| Patent document cited in search report | | | Publication date (day/month/year) | Patent family member(s) | Publication date (day/month/year) |
|---|---|---|---|---|---|
| JP | 2010-3854 | A | 07 January 2010 | (Family: none) | |
| JP | 2010-278228 | A | 09 December 2010 | (Family: none) | |
| WO | 2018/212345 | A1 | 22 November 2018 | (Family: none) | |
| JP | 2004-277868 | A | 07 October 2004 | (Family: none) | |
| JP | 2012-119572 | A | 21 June 2012 | (Family: none) | |
| JP | 7-212015 | A | 11 August 1995 | (Family: none) | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020150004 A
- JP 4539284 B
- JP 2007110054 A
- WO 2018212345 A